# EUROPEAN PATENT SPECIFICATION

(11) **EP 3 168 866 B1**
(45) Date of publication and mention of the grant of the patent: **30.12.2020**
(21) Application number: 15194745.4
(22) Date of filing: 16.11.2015
(51) Int. Cl.: H01L 23/31, G01N 27/12

(54) **SEMICONDUCTOR HUMIDITY SENSOR DEVICE AND MANUFACTURING METHOD THEREOF**
HALBLEITENDE FEUCHTESENSORVORRICHTUNG UND DEREN HERSTELLUNGSVERFAHREN
DISPOSITIF CAPTEUR D'HUMIDITÉ À SEMI-CONDUCTEUR ET SON PROCÉDÉ DE FABRICATION

(43) Date of publication of application: 17.05.2017
(73) Proprietor: ams AG, 8141 Premstätten (AT)
(72) Inventor: Nenadovic, Nebojsa, 5656 AE Eindhoven (NL); Sakic, Agata, 5656 AE Eindhoven (NL); Zandt, Michael, 5656 AE Eindhoven (NL); Vanhelmont, Frederik Willem Maurits, 5656 AE Eindhoven (NL); Suy, Hilco, 5656 AE Eindhoven (NL); Daamen, Roel, 5656 AE Eindhoven (NL)
(74) Representative: Epping - Hermann - Fischer

(56) References cited:
- DE-T5-112013 004 203
- JP-A- 2002 162 380
- JP-A- 2012 068 054
- US-A1- 2009 243 015

## Description

Semiconductor devices are provided for various applications including sensors, in particular relative humidity sensors. A humidity sensor must be in contact with the environment and can thus be subject to condensation. Many sensor applications require fast recovery from condensation. Water droplets that are present on the sensor region should instantaneously vanish when the temperature rises above the dew point, which is the temperature at which the water vapor in a sample of air at constant barometric pressure condenses into liquid water at the same rate at which it evaporates.

US 2013/0069176 A1 discloses an integrated circuit package comprising a sensor element area covered with a protection layer. The integrated circuit is mounted on a carrier and connected by bond wires. An encapsulation covering the bond wires has an opening over the sensor element area. Inside the opening the protection layer comprises a channel surrounding the sensor element area.

JP 2010-050452 A discloses a method for manufacturing a sensor device with a plurality of chips arranged on a lead frame. A detector structure of the chips may comprise a polymer membrane of a humidity sensor. A buffer layer is formed above an integrated electronic circuit and leaves the detector structure free. A molded cover touches the buffer layer at the periphery of the detector structure, thus forming a sealed cavity above the detector structure.

JP 2012-068054 A discloses an electrostatic capacitance-type humidity sensor comprising a moisture-sensitive film surrounded by a hydrophilic film, which has a groove where condensed water forms a film. If the temperature of the air around the humidity sensor becomes higher than the dew-point temperature, the water in the groove part of the hydrophilic film evaporates, and dirt contained in the water remains.

US 2009/0243015 A1 discloses a method for manufacturing a semiconductor device wherein a resin layer is formed on an upper surface of a substrate including a photodiode such that the resin layer does not cover a light receiving region. Concentric grooves are formed in the resin layer so that the grooves surround the light receiving region. The photodiode is sealed with a molding resin. The grooves prevent molding resin from flowing into the light receiving region.

DE 112013004203 T5 discloses a sensor device comprising a moisture-sensitive layer, which is provided with a depression to prevent resin from entering a measurement portion during molding.

JP 2002-162380 A discloses a semiconductor ion sensor comprising a recessed portion around the ion sensing section. The recessed portion prevents inflow of resin into the ion sensing section.

It is an object of the invention to present a semiconductor humidity sensor device, especially a relative humidity sensor, that provides fast removal of condensation without internal heating. It is a further object of the invention to present a method of producing such a device.

These objects are achieved with the semiconductor humidity sensor device according to claim 1 and with the method of producing a semiconductor humidity sensor device according to claim 5. Further embodiments and variants derive from the dependent claims.

The semiconductor humidity sensor device comprises a substrate with a main surface, a sensor region on or above the main surface, a sensor element in the sensor region, a coating layer above the main surface, and a trench formed in the coating layer around the sensor region. The trench provides drainage of a liquid from the coating layer.
A hydrophilic liner is arranged between the main surface and the coating layer. The hydrophilic liner is exposed in the trench.

In a further embodiment a channel is formed in the coating layer around the sensor region, so that the trench is arranged between the sensor region and the channel.

In a further embodiment a molding compound is arranged on or above the coating layer, so that the sensor region and the trench are not covered by the molding compound, and the channel completely surrounds an area that is entirely free from the molding compound.

The trench completely surrounds an area, and this area may be entirely covered by the coating layer. The upper surface of the coating layer is plane in this area.

In a further embodiment the coating layer comprises a moisture sensitive material.

The method of producing a semiconductor humidity sensor device comprises forming a coating layer encompassing a sensor region including a sensor element on or above a main surface of a substrate, and forming a trench in the coating layer around the sensor region, the trench providing drainage of a liquid from the coating layer.
A hydrophilic liner is arranged between the main surface and the coating layer, and the hydrophilic liner is exposed in the trench.
In a further variant of the method, the coating layer is formed from a moisture sensitive material.
The sensor element is arranged in the sensor region and completely covered with the coating layer, which is formed of a material that can be penetrated by moisture.

In a further variant of the method, a channel is formed in the coating layer, the channel completely surrounding an area including the sensor region, so that the trench is arranged between the sensor region and the channel, a molding compound is applied on or above the coating layer, so that the sensor region and the trench are not covered by the molding compound, and the channel is used as a barrier to prevent the molding compound from extending into the area surrounded by the channel.
The trench is formed completely surrounding an area, which may be entirely covered by the coating layer.
In the area surrounded by the trench, the coating layer has a plane upper surface facing away from the substrate.
In the following, embodiments and variants of the invention are described in more detail in conjunction with the accompanying figures.
Figure 1 is a cross section of an embodiment of the semiconductor humidity sensor device.
Figure 2 is a top view of the embodiment shown in Figure 1. Figure 1 shows an integrated circuit package comprising the substrate 1 of the semiconductor humidity sensor device, which comprises a sensor region 3 on or above an upper main surface 2. The substrate 1 comprises a semiconductor body, which may include an integrated circuit like a CMOS circuit, for instance, and may be provided with a conventional wiring formed by metallization layers and intermetal dielectric.

A coating layer 4 is applied above the main surface 2. The coating layer 4 may be typically 4 to 5 µm thick, for example. The coating layer 4 can comprise organic or inorganic material. It may in particular comprise a polymer, for instance. The coating layer 4 may especially be provided as a sensitive layer. It may comprise a moisture sensitive material provided for a humidity sensor, especially a relative humidity sensor. Polyimide may be used for the coating layer 4, in particular as a moisture sensitive material.

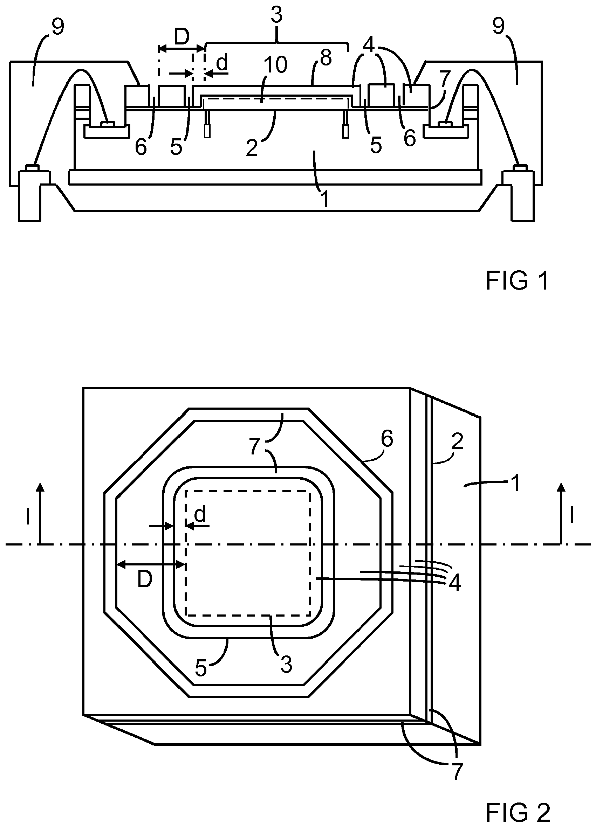

A sensor element 10 is arranged in the sensor region 3, as in the embodiment shown in Figure 1 by way of example. The sensor element 10 comprises a humidity sensor. Details of the sensor element 10 are not relevant to the invention and are not shown in Figure 1. The coating layer 4 covers the sensor element 10. The sensor element 10 is provided for a humidity sensor and it is completely covered, and the coating layer 4 is formed of a material that can be penetrated by moisture, such as polyimide, for instance.

The coating layer 4 may especially comprise a photo-definable layer, i. e., a layer that can be patterned by the use of photolithography, and may in particular comprise a photoresist. If the coating layer 4 does not comprise a photo-definable layer, a dedicated photoresist layer may be applied and patterned by standard photolithography to form a mask for etching the coating layer 4.

A trench 5 in the coating layer 4 is formed in the vicinity of the sensor region 3. The trench 5 surrounds the sensor region 3, partially or completely. The trench 5 is provided to drain a liquid, especially water, which may condense on the surface of the coating layer 4, especially above the sensor region 3. The distance d between the sensor region 3 and the trench 5 may be smaller than 5 µm.

The trench 5 may completely surround the sensor region 3. In this case, the coating layer 4 may cover the entire area that is surrounded by the trench 5. In this area, the coating layer 4 may in particular comprise an essentially plane upper surface 8 as shown in Figure 1.

A hydrophilic liner 7 is arranged between the main surface 2 and the coating layer 4, as shown in Figure 1 by way of example. In this case, the hydrophilic liner 7 may be recessed in an area outside the trench 5, in particular in the sensor region 3. The hydrophilic liner 7 may be arranged on or above the sensor element 10, as shown in Figure 1 by way of example, or under the sensor element 10. The hydrophilic liner 7 helps to drain the liquid from the upper surface 8 of the coating layer 4 into the trench 5, especially as the hydrophilic liner 7 is exposed at the bottom of the trench 5.

A channel 6 may be formed around the sensor region 3 and around the trench 5. In some embodiments, the distance D between the sensor region 3 and the channel 6 may be at least three times as large as the distance d between the sensor region 3 and the trench 5. The channel 6 acts as a trap for a molding compound 9 that is used as encapsulation material. The advantage of the channel 6 for the molding process is explained in detail in US 2013/0069176 A1 cited above. The molding compound 9 can be provided to cover interconnects in the form of bond wires between an integrated circuit of the substrate 1 and a lead frame, on which the substrate 1 may be mounted. The lead frame provides external connections or terminals of the integrated circuit.

The molding compound 9 does not cover the sensor region 3 and the trench 5. In particular, the channel 6 may at least approximately delimit the area of an opening in the molding compound 9 where the upper surface 8 of the coating layer 4 may be bare to be sufficiently exposed to the environmental conditions.

The sensor element 10 may be arranged within the sensor region 3 on or above the main surface 2 of the substrate 1, as in the embodiment shown in Figure 1 by way of example. For a relative humidity sensor, its operation is substantially improved by the fast recovery from condensation that is achieved with the trench 5. The sensor element may instead be embedded in the substrate 1, provided that the position is appropriate for the sensing operation.

Figure 2 is a top view of the embodiment according to Figure 1. The position of the cross section of Figure 1 is indicated in Figure 2. The reference numerals of corresponding elements are the same in both figures. Figure 2 shows the trench 5 completely surrounding the sensor region 3 at a small distance d. The trench 5 can thus be confined to the periphery of the sensor region 3 in view of an effective drainage. In the embodiment according to Figure 2, the boundary of the sensor region 3 is a square, but it may have any other shape. The sensor region 3 may typically occupy an area of about 0.1 × 0.1 mm². If the trench 5 closely follows the boundary of the sensor region 3, it has essentially the same shape, as can be seen from Figure 2. The trench 5 is arranged at locations where condensation is to be drained, but it is not necessary that the trench 5 completely surrounds the sensor region 3 and forms a closed path.

The channel 6 may be provided to block the molding compound 9, which is not shown in Figure 2, from the area provided for the opening. For this purpose the shape of the channel 6 may be adapted to the outer limit of the opening, which may form an octagon, as shown in Figure 2, or have any other suitable shape like a circle or a square, for instance. The channel 6 is arranged at a larger distance D from the sensor region 3 around the trench 5. In further embodiments, a minimum value of the distance D between the sensor region 3 and the channel 6 may be at least three times as large as a maximum value of the distance d between the sensor region 3 and the trench 5.

The trench 5 may be formed as a slit penetrating the coating layer 4. If a channel 6 is provided, it may also penetrate the coating layer 4. If such a slit completely surrounds the sensor region 3, the coating layer 4 is divided into separate portions, which are indicated in Figure 2. The hydrophilic liner 7 is exposed at the bottom of the trench 5 and may also be exposed at the bottom of the channel 6. This is also indicated in Figure 2. The hydrophilic liner 7 attracts humidity and thus helps to drain liquid from the upper surface 8 of the coating layer 4.

If a photo-definable layer, like a photo-definable polymer, for instance, is used for the coating layer 4, it can be patterned by photolithography. If another material, like BCB (benzocyclobutene) for example, is applied to form the coating layer 4, the trench 5 can be etched into the coating layer 4. In this case, a photo-definable layer, like a photoresist for instance, may be applied and patterned for defining the trench 5.

The invention presents an improved way to enable fast recovery from condensation on sensors, in particular relative humidity sensors, by utilizing a slit or trench to collect condensed water. The trench is a passive element, which does not require electric operation and power consumption like an implemented heater. The formation of the trench is comparably easy and hence cheap. On the other hand it provides quick and effective drainage of liquid droplets.

## Claims

1. A semiconductor humidity sensor device, comprising:
- a substrate (1) comprising a main surface (2),
- a sensor region (3) on, above, or embedded in the main surface (2),
- a sensor element (10) in the sensor region (3), and
- a coating layer (4) above the main surface (2), the coating layer (4) encompassing the sensor region (3),
- wherein the sensor element (10) is completely covered by the coating layer (4),
- the coating layer (4) is formed of a material that can be penetrated by moisture,
- a trench (5) is formed in the coating layer (4) around the sensor region (3), the trench (5) providing drainage of a liquid from the coating layer (4),
- the coating layer (4) has an upper surface (8) facing away from the substrate (1), the upper surface (8) being plane in an area surrounded by the trench (5), and
- the sensor element (10) is a humidity sensor,
**characterized in that**
- a hydrophilic liner (7) is arranged between the main surface (2) and the coating layer (4), and
- the hydrophilic liner (7) is exposed in the trench (5).

2. The semiconductor humidity sensor device according to claim 1, further comprising:
- a channel (6) formed in the coating layer (4) around the sensor region (3), the trench (5) being arranged between the sensor region (3) and the channel (6).

3. The semiconductor humidity sensor device according to claim 2, further comprising:
- a molding compound (9) being arranged on or above the coating layer (4),
- the sensor region (3) and the trench (5) not being covered by the molding compound (9), and
- the channel (6) completely surrounding an area that is entirely free from the molding compound (9).

4. The semiconductor humidity sensor device according to one of claims 1 to 3, wherein the trench (5) completely surrounds an area that is entirely covered by the coating layer (4).

5. A method of producing a semiconductor humidity sensor device, comprising:
- forming a coating layer (4) encompassing a sensor region (3) including a sensor element (10) on, above, or embedded in a main surface (2) of a substrate (1),
- arranging a hydrophilic liner (7) between the main surface (2) and the coating layer (4), wherein
- the sensor element (10) is completely covered by the coating layer (4),
- the coating layer (4) is formed of a material that can be penetrated by moisture,
- forming a trench (5) in the coating layer (4) around the sensor region (3), to expose the hydrophilic liner (7), the trench (5) providing drainage of a liquid from the coating layer (4),
- whereby in an area surrounded by the trench (5), the coating layer (4) is formed so that it has a plane upper surface (8) facing away from the substrate (1), and
- the sensor element (10) is a humidity sensor.

6. The method of producing a semiconductor humidity sensor device according to claim 5, further comprising:
- forming a channel (6) in the coating layer (4), the channel (6) completely surrounding an area including the sensor region (3), so that the trench (5) is arranged between the sensor region (3) and the channel (6),
- applying a molding compound (9) on or above the coating layer (4), so that the sensor region (3) and the trench (5) are not covered by the molding compound (9), and
- using the channel (6) as a barrier to prevent the molding compound (9) from extending into the area surrounded by the channel (6).

7. The method of producing a semiconductor humidity sensor device according to one of claims 5 to 6, wherein the trench (5) is formed completely surrounding an area that is entirely covered by the coating layer (4).

## Patentansprüche

1. Halbleiterfeuchtigkeitssensorvorrichtung, umfassend:
- ein Substrat (1), das eine Hauptfläche (2) umfasst,
- eine Sensorzone (3), die auf der, über der oder in die Hauptfläche (2) eingebettet ist,
- ein Sensorelement (10) in der Sensorzone (3), und
- eine Überzugsschicht (4) über der Hauptfläche (2), wobei die Überzugsschicht (4) die Sensorzone (3) umschließt,
- wobei das Sensorelement (10) von der Überzugsschicht (4) vollständig bedeckt ist,
- die Überzugsschicht (4) aus einem Material gebildet ist, das von Feuchtigkeit durchdrungen werden kann,
- ein Graben (5) in der Überzugsschicht (4) um die Sensorzone (3) herum ausgebildet ist, wobei der Graben (5) für einen Abzug einer Flüssigkeit aus der Überzugsschicht (4) sorgt,
- die Überzugsschicht (4) eine Oberfläche (8) hat, die vom Substrat (1) abgewandt ist, wobei die Oberfläche (8) in einem vom Graben (5) umgebenen Bereich eben ist, und
- das Sensorelement (10) ein Feuchtigkeitssensor ist, **dadurch gekennzeichnet, dass**
- eine hydrophile Auskleidung (7) zwischen der Hauptfläche (2) und der Überzugsschicht (4) angeordnet ist, und
- die hydrophile Auskleidung (7) im Graben (5) freiliegt.

2. Halbleiterfeuchtigkeitssensorvorrichtung nach Anspruch 1, darüber hinaus umfassend:
- einen Kanal (6), der in der Überzugsschicht (4) um die Sensorzone (3) herum ausgebildet ist, wobei der Graben (5) zwischen der Sensorzone (3) und dem Kanal (6) angeordnet ist.

3. Halbleiterfeuchtigkeitssensorvorrichtung nach Anspruch 2, darüber hinaus umfassend:
- eine Formmasse (9), die auf oder über der Überzugsschicht (4) angeordnet ist,
- die Sensorzone (3) und der Graben (5) nicht von der Formmasse (9) bedeckt sind, und
- der Kanal (6) einen Bereich vollständig umgibt, der gänzlich frei von der Formmasse (9) ist.

4. Halbleiterfeuchtigkeitssensorvorrichtung nach einem der Ansprüche 1 bis 3, wobei der Graben (5) einen Bereich vollständig umgibt, der gänzlich von der Überzugsschicht (4) bedeckt ist.

5. Verfahren zum Herstellen einer Halbleiterfeuchtigkeitssensorvorrichtung, umfassend:
- Ausbilden einer Überzugsschicht (4), die eine ein Sensorelement (10) enthaltende Sensorzone (3) umschließt, die auf einer, über einer oder in eine Hauptfläche (2) eines Substrats (1) eingebettet ist,
- Anordnen einer hydrophilen Auskleidung (7) zwischen der Hauptfläche (2) und der Überzugsschicht (4),
wobei
- das Sensorelement (10) von der Überzugsschicht (4) vollständig bedeckt ist,
- die Überzugsschicht (4) aus einem Material gebildet ist, das von Feuchtigkeit durchdrungen werden kann,
- Ausbilden eines Grabens (5) in der Überzugsschicht (4) um die Sensorzone (3) herum, um die hydrophile Auskleidung (7) freizulegen, wobei der Graben (5) für einen Abzug einer Flüssigkeit aus der Überzugsschicht (4) sorgt,
- wobei in einem vom Graben (5) umgebenen Bereich die Überzugsschicht (4) so ausgebildet ist, dass sie eine ebene Oberfläche (8) hat, die vom Substrat (1) abgewandt ist, und
- das Sensorelement (10) ein Feuchtigkeitssensor ist.

6. Verfahren zum Herstellen einer Halbleiterfeuchtigkeitssensorvorrichtung nach Anspruch 5, darüber hinaus umfassend:
- Ausbilden eines Kanals (6) in der Überzugsschicht (4), wobei der Kanal (6) einen Bereich vollständig umgibt, der die Sensorzone (3) enthält, und zwar so, dass der Graben (5) zwischen der Sensorzone (3) und dem Kanal (6) angeordnet ist,
- Aufbringen einer Formmasse (9) auf oder über der Überzugsschicht (4) so, dass die Sensorzone (3) und der Graben (5) nicht von der Formmasse (9) bedeckt sind, und
- Verwenden des Kanals (6) als Sperre, um zu verhindern, dass sich die Formmasse (9) in den vom Kanal (6) umgebenen Bereich ausbreitet.

7. Verfahren zum Herstellen einer Halbleiterfeuchtigkeitssensorvorrichtung nach einem der Ansprüche 5 bis 6, wobei der Graben (5) einen Bereich vollständig umgebend ausgebildet ist, der gänzlich von der Überzugsschicht (4) bedeckt ist.

## Revendications

1. Dispositif de capteur d'humidité à semiconducteur, comprenant :
- un substrat (1) comprenant une surface principale (2),
- une région de capteur (3) logée sur, au-dessus, ou dans la surface principale (2),
- un élément de capteur (10) dans la région de capteur (3), et
- une couche de revêtement (4) au-dessus de la surface principale (2), la couche de revêtement (4) englobant la région de capteur (3),
- sachant que l'élément de capteur (10) est entièrement recouvert par la couche de revêtement (4),
- la couche de revêtement (4) est composée d'un matériau qui peut s'imprégner d'humidité,
- un sillon (5) est formé dans la couche de revêtement (4) autour de la région de capteur (3), le sillon (5) assurant un drainage d'un liquide depuis la couche de revêtement (4),
- la couche de revêtement (4) présente une surface supérieure (8) détournée du substrat (1), la surface supérieure (8) étant plane dans une zone entourée par le sillon (5), et
- l'élément de capteur (10) est un capteur d'humidité, **caractérisé en ce que**
- un garnissage hydrophile (7) est agencé entre la surface principale (2) et la couche de revêtement (4), et
- le garnissage hydrophile (7) est exposé dans le sillon (5) .

2. Le dispositif de capteur d'humidité à semiconducteur selon la revendication 1, comprenant en outre :
- un canal (6) formé dans la couche de revêtement (4) autour de la région de capteur (3), le sillon (5) étant agencé entre la région de capteur (3) et le canal (6).

3. Dispositif de capteur d'humidité à semiconducteur selon la revendication 2, comprenant en outre :
- un composé de moulage (9) qui est agencé sur ou au-dessus de la couche de revêtement (4),
- la région de capteur (3) et le sillon (5) qui ne sont pas recouverts par le composé de moulage (9), et
- le canal (6) entourant entièrement une zone qui est entièrement dépourvue du composé de moulage (9).

4. Dispositif de capteur d'humidité à semiconducteur selon l'une des revendications 1 à 3, sachant que le sillon (5) entoure entièrement une zone qui est entièrement recouverte par la couche de revêtement (4).

5. Procédé de production d'un dispositif de capteur d'humidité à semiconducteur, comprenant :
- la formation d'une couche de revêtement (4) englobant une région de capteur (3) incluant un élément de capteur (10) logée sur, au-dessus, ou dans une surface principale (2) d'un substrat (1),
- l'agencement d'un garnissage hydrophile (7) entre la surface principale (2) et la couche de revêtement (4), sachant que
- l'élément de capteur (10) est entièrement recouverte par la couche de revêtement (4),
- la couche de revêtement (4) est composée d'un matériau qui peut s'imprégner d'humidité,
- la formation d'un sillon (5) dans la couche de revêtement (4) autour de la région de capteur (3) pour exposer le garnissage hydrophile (7), le sillon (5) assurant un drainage d'un liquide depuis la couche de revêtement (4),
- sachant que dans une zone entourée par le sillon (5), la couche de revêtement (4) est formée de telle sorte qu'elle présente une surface supérieure (8) plane détournée du substrat (1), et
- l'élément de capteur (10) est un capteur d'humidité.

6. Le procédé de production d'un dispositif de capteur d'humidité à semiconducteur selon la revendication 5, comprenant en outre :
- la formation d'un canal (6) dans la couche de revêtement (4), le canal (6) entourant entièrement une zone incluant la région de capteur (3), de telle sorte que le sillon (5) soit agencé entre la région de capteur (3) et le canal (6),
- l'application d'un composé de moulage (9) sur ou au-dessus de la couche de revêtement (4), de telle sorte que la région de capteur (3) et le sillon (5) ne soient pas recouverts par le composé de moulage (9), et
- l'utilisation du canal (6) comme barrière pour empêcher le composé de moulage (9) de s'étendre dans la zone entourée par le canal (6).

7. Le procédé de production d'un dispositif de capteur d'humidité à semiconducteur selon l'une des revendications 5 à 6, sachant que le sillon (5) est formé de manière à entourer entièrement une zone qui est entièrement recouverte par la couche de revêtement (4).
